(19) Europäisches Patentamt
European Patent Office
Office européen des brevets

(11) **EP 1 445 865 B1**

(12) **FASCICULE DE BREVET EUROPEEN**

(45) Date de publication et mention
de la délivrance du brevet:
**22.08.2007 Bulletin 2007/34**

(51) Int Cl.:
*H03K 23/68* (2006.01) *H03K 23/66* (2006.01)

(21) Numéro de dépôt: **04100453.2**

(22) Date de dépôt: **06.02.2004**

(54) **Diviseur de frequence a structure entonnoir**

Frequenzteiler mit Trichterstruktur

Frequency divider with funnel structure

(84) Etats contractants désignés:
**AT BE BG CH CY CZ DE DK EE ES FI FR GB GR HU IE IT LI LU MC NL PT RO SE SI SK TR**

(30) Priorité: **07.02.2003 FR 0301485**

(43) Date de publication de la demande:
**11.08.2004 Bulletin 2004/33**

(73) Titulaire: **Thales**
**92200 Neuilly Sur Seine (FR)**

(72) Inventeurs:
• **De Gouy, Jean-Luc**
**THALES Intellectual Property**
**94117 Arcueil Cedex (FR)**

• **Gabet, Pascal**
**THALES Intellectual Property**
**94117 Arcueil Cedex (FR)**
• **Neveu, Gilles**
**THALES Intellectual Property**
**94117 Arcueil Cedex (FR)**

(74) Mandataire: **Lucas, Laurent Jacques et al**
**Marks & Clerk France**
**31-33 Avenue Aristide Briand**
**94117 Arcueil Cedex (FR)**

(56) Documents cités:
**US-A- 6 035 182** **US-B1- 6 369 623**

**Description**

L'objet de l'invention concerne un diviseur de fréquence.

Il concerne notamment un diviseur de fréquence multi-octaves à structure dite entonnoir et sortie synchrone.

Elle trouve son application dans le domaine de la synthèse de fréquence et plus particulièrement dans le domaine de la synthèse à boucles de phase.

Elle peut aussi constituer une cellule de base d'un composant numérique programmable de type FPGA (Field Programmable Gate Array), DSP (Digital Signal Processing).

Elle peut aussi être utilisée pour des générateurs d'impulsions à très faible instabilité (ou en terme anglo-saxon jitter).

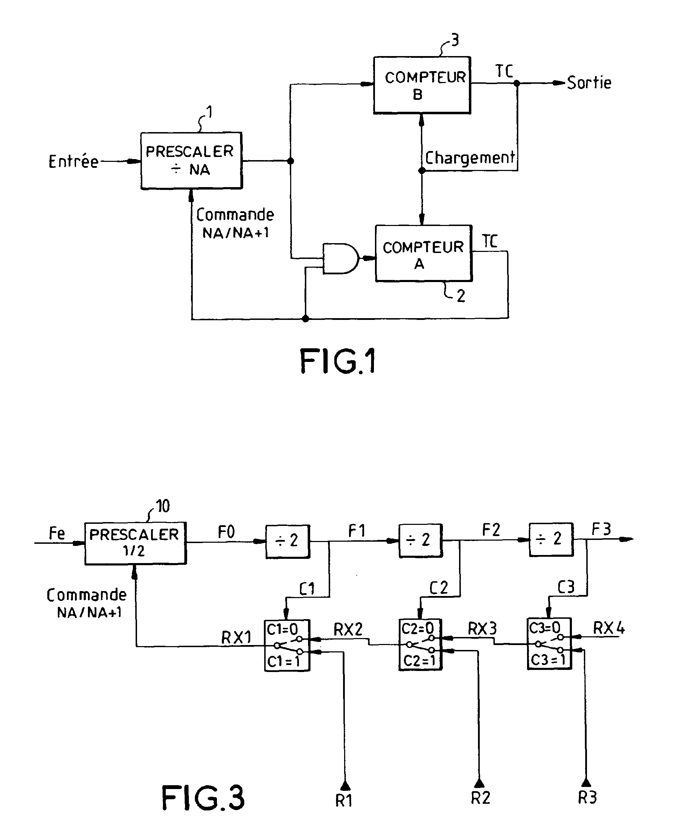

La figure 1 représente un exemple de diviseur selon l'art antérieur.

Il est composé d'un étage d'adaptation 1 ou « prescaler » qui divise par Na ou par Na+1 la fréquence d'entrée Fe, d'un premier compteur A, référencé 2, dont la sortie TC commande la division par Na ou par Na+1 de l'étage d'adaptation, d'un deuxième compteur B, 3, dont la sortie TC est la sortie du diviseur.

L'ensemble fonctionne de la façon suivante : lorsque le compteur B arrive en fin de comptage (ce qui correspond à la fin de trame), il délivre le signal TC qui recharge respectivement les deux compteurs avec les valeurs A et B, en respectant B≥A. Une nouvelle trame commence ensuite. Tant que le compteur A n'a pas fini de compter, l'étage d'adaptation 1 divise la fréquence d'entrée Fe par Na+1. C'est-à-dire qu'à chaque fois que A et B sont décomptés d'une unité, l'étage d'adaptation 1 compte (Na+1) cycles du signal d'entrée de période Te. Le compteur A arrive donc en fin de comptage au bout de A*(Na+1) cycles de durée Te. A ce moment, le compteur A se bloque et commande à l'étage d'adaptation de diviser par Na. Pour arriver en fin de comptage, le compteur B doit encore compter B-A, ce qui correspond à Na*(B-A) cycles du signal d'entrée. Le dispositif est alors revenu dans les conditions initiales.

Le nombre total de cycles du signal d'entrée pendant une trame donne le rang de division N du diviseur :

$$N = A(Na+1) + Na(B-A)$$

$$N = A + BNa$$

Pour que N évolue en continuité par pas de 1, il faut que A soit programmable entre 0 et Na-1. B étant plus grand ou égal à A, on a

$$Bmin = Na-1.$$

donc Mmin = Na*(Na-1).

Pour un étage d'adaptation 4/5 le rang minimum de division (pour avoir continuité par pas de 1) est donc égal à 12. Une telle structure présente notamment les inconvénients suivants :

- Les compteurs A et B sont des compteurs synchrones dont tous les étages doivent fonctionner à fréquence élevée égale à Fe/Na,
- Pour un rang de division N variant de quelques unités à plusieurs centaines, ces compteurs synchrones conduisent à une consommation très importante (compte tenu d'une fréquence élevée de fonctionnement et d'un grand nombre d'étages),
- L'implémentation des modes fractionnaires n'est pas aisée,
- Le nombre de couches logiques entre l'entrée et la sortie est généralement important ce qui limite les performances de bruit de phase.

La demande de brevet US 6,035,182 montre un exemple de diviseur de fréquences.

L'invention concerne un diviseur de fréquence permettant de diviser par N une fréquence Fe et comportant au moins un étage d'adaptation suivi d'une chaîne de division. Il est caractérisé en ce que :

- l'étage d'adaptation a au moins une entrée pour le signal de fréquence à diviser Fe, une entrée pour une commande NA du rang de base de division de l'étage d'adaptation et une entrée pour une commande ΔNA provenant de la chaîne de divisioin et permettant de faire varier NA d'une unité,
- la chaîne de division comporte au moins un étage (K) de division comportant au moins un diviseur par 2, fournissant une fréquence divisée F(K), un commutateur commandé par le diviseur par 2, le commutateur a une entrée pour une donnée de programmation R(K), une entrée pour le signal de retenue RX(K+1) de l'étage suivant et une sortie pour le signal de retenue RX(K) pour l'étage précédent.

Dans le cas où il y a un étage unique le signal de retenue RX(K) est la commande $\Delta$NA.

La commande NA du rang de division variant de N0 à 2*N0-1 où N0 est le rang minimum de l'étage d'adaptation et une commande $\Delta$NA = NA+1 afin d'incrémenter le rang de division NA d'une unité. N0 est par exemple une puissance de 2, la commande NA varie par exemple de $2^P$ à $2^{(P+1)}$-1.

Le dispositif selon l'invention présente notamment les avantages suivants :

- Les performances de vitesse dépendent uniquement de l'étage de tête, en d'autres termes, il est possible d'étendre (à l'infini) le rang de division N sans diminution de la fréquence de fonctionnement de l'ensemble de diviseur,
- La structure du diviseur selon l'invention permet d'obtenir la fonctionnalité équivalente à la division par un compteur synchrone et cela quelque soit la longueur de comptage,
- Elle est facile à mettre en oeuvre dans un composant numérique discrets ou bien en logique intégrée du type FPGA ou ASIC,
- Elle permet d'améliorer les performances des synthétiseurs à boucles de phase et à pas fractionnaires,
- Le rapport cyclique du signal de sortie est de 50% lorsque le rang de division N est pair et est la valeur la plus proche de 50% lorsque le rang de division est impair.

D'autres caractéristiques et avantages de l'invention apparaîtront mieux à la lecture de la description qui suit d'un exemple détaillé donné à titre illustratif et nullement limitatif annexé des figures qui représentent :

- La figure 1 un exemple d'architecture d'un diviseur de fréquence selon l'art antérieur,
- La figure 2 un exemple d'architecture de base d'un diviseur de fréquence selon l'invention,
- La figure 3 un exemple de mise en oeuvre du diviseur selon l'invention,
- La figure 4 un tableau donnant la propagation des retenues et la durée des états hauts et bas pour l'exemple de la figure 3,
- Les figures 5A et 5B un exemple de réalisation comprenant une sortie synchrone et le chronogramme associé,
- La figure 6 un exemple de réalisation de la sortie synchrone à l'aide d'une bascule JK,
- La figure 7 un exemple de réalisation de la sortie synchrone avec choix de la polarité,
- La figure 8 une autre variante de réalisation,
- La figure 9 un exemple d'architecture pour le changement de rang de division,
- La figure 10 un synoptique d'un diviseur multi-octaves selon l'invention,
- La figure 11 un synoptique d'un exemple d'étage de rang K du diviseur selon l'invention,
- La figure 12 un schéma de la machine d'état asynchrone à 8 états,
- La figure 13 un schéma de la machine d'état asynchrone pour l'étage K du diviseur de fréquence selon l'invention.

Le terme « prescaler » ou étage d'adaptation désigne, dans la présente invention, un diviseur placé en tête d'une chaîne de division, présentant généralement une structure simple et fonctionnant à vitesse élevée.

Tout autre dispositif ayant des caractéristiques fonctionnelles identiques ou sensiblement identiques à cet étage d'adaptation peut être utilisé.

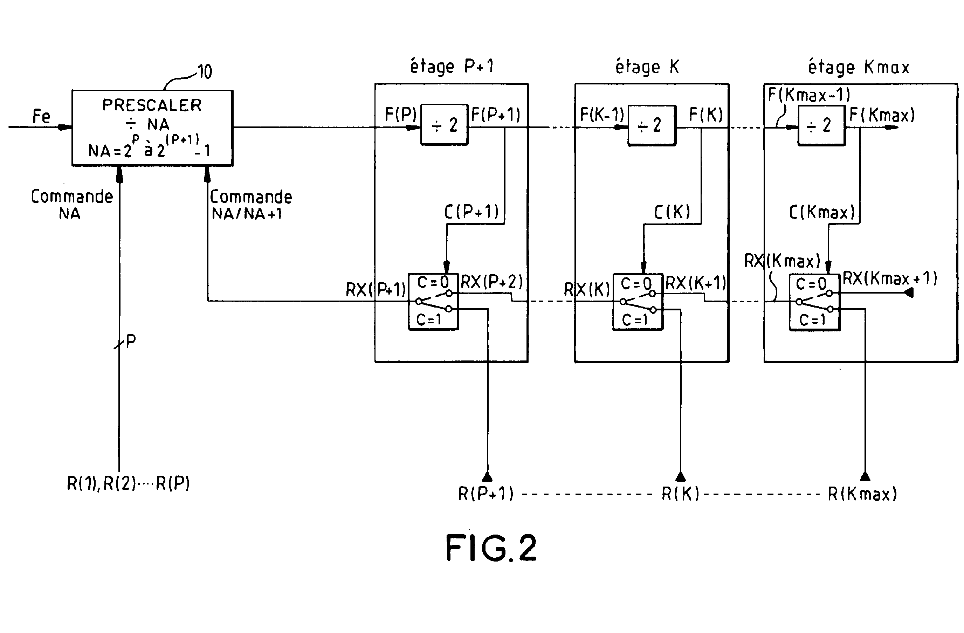

La figure 2 représente un exemple de réalisation d'un diviseur de fréquence selon l'invention.

Il comporte par exemple un étage d'adaptation 10 dont le rang de division NA varie sur un octave ou sensiblement sur un octave. l'étage d'adaptation a une entrée qui reçoit le signal à diviser Fe, une entrée pour une commande NA du rang de base de division de l'étage d'adaptation, une entrée pour une commande NA/(NA+1) (permettant de faire varier, le rang de division de l'étage d'adaptation d'une unité, par exemple de l'incrémenter d'une unité) provenant d'un bloc 11 comprenant un ou plusieurs étages de division identiques ou sensiblement identiques.

L'étage d'adaptation a par exemple un rang de division NA variant de N0 à 2*N0-1 où N0 est le rang minimum de l'étage d'adaptation.

Dans l'exemple donné ci-après à titre illustratif et nullement limitatif, NA peut prendre les valeurs $2^P$ à $2^{(P+1)}$-1 suivant la valeur du mot de commande du rang de division NA, référencé 12 et représenté par les bits R(1), R(2)....R(P). En outre une commande NA/NA+1, référencée 13, qui provient de l'étage de division suivant, permet de diviser par NA ou NA+1 suivant la valeur 0 ou 1 de cette commande. (La valeur de P est choisie par exemple pour que l'étage d'adaptation ait un chemin critique optimal).

Pour P=0, l'étage d'adaptation est un diviseur par 1 qui ne reçoit que la commande NA/NA+1 qui permet de diviser par 1 ou par 2.

Pour P = 1, l'étage d'adaptation divise par NA = 2 ou 3 suivant la valeur de R (1). La commande NA/NA + 1 permet de réaliser les variations 2 à 3 où 3 à 4 suivant la valeur de R (1).

Pour P=2, l'étage d'adaptation divise par NA=4, 5, 6, 7 et la commande NA/NA+1 permet de réaliser les variations 4/5, 5/6, 6/7 et 7/8. Et ainsi de suite pour les autres valeurs de P.

Dans cet exemple, l'étage d'adaptation 10 est suivi de Kmax-P étages qui ont une fonctionnalité identique ou sensiblement identique et qui sont mis en série pour former le diviseur. Le diviseur ainsi formé dans cet exemple de réalisation permet de diviser par un rang compris entre $2^{Kmax}$ et $2^{(Kmax+1)}$-1 avec une commande RX(Kmax+1) qui permet d'augmenter d'une unité le rang de division.

Un étage K de division comporte par exemple un diviseur par 2, référencé $14_K$ dont l'entrée est F(K-1) (fréquence issue de l'étage précédent K-1) et dont la sortie est F(K), fréquence qui correspond à l'entrée de l'étage suivant (K+1). L'étage K comporte aussi un commutateur à deux entrées $15_K$ qui est commandé par la sortie du diviseur par 2, $14_K$. Une première entrée du commutateur est le signal de retenue RX(K+1) qui provient de l'étage suivant (nommé(K+1)), la deuxième entrée du commutateur est la donnée de programmation R(K), ligne $16_K$. La sortie du commutateur $15_K$ est le signal de retenue RX(K) qui est une des 2 entrées du commutateur $15_{K-1}$ de l'étage K-1.

Pour l'étage K=P+1, la sortie du commutateur $15_{P+1}$ est la commande NA/NA+1 de l'étage d'adaptation. L'ajout de l'étage P+1 derrière l'étage d'adaptation 10 permet d'obtenir un diviseur qui divise par un rang programmable NA' compris entre $2^{(P+1)}$ à $2^{(P+2)}$ -1 et qui comporte une entrée RX(P+2) qui effectue la commande NA'/NA'+1. L'ajout de Kmax-P étages derrière l'étage d'adaptation permet d'obtenir un diviseur qui divise par un rang programmable compris entre $2^{(Kmax)}$ à $2^{(Kmax+1)}$ -1. Ce rang de division peut être incrémenté de 1 par la commande RX(Kmax+1).

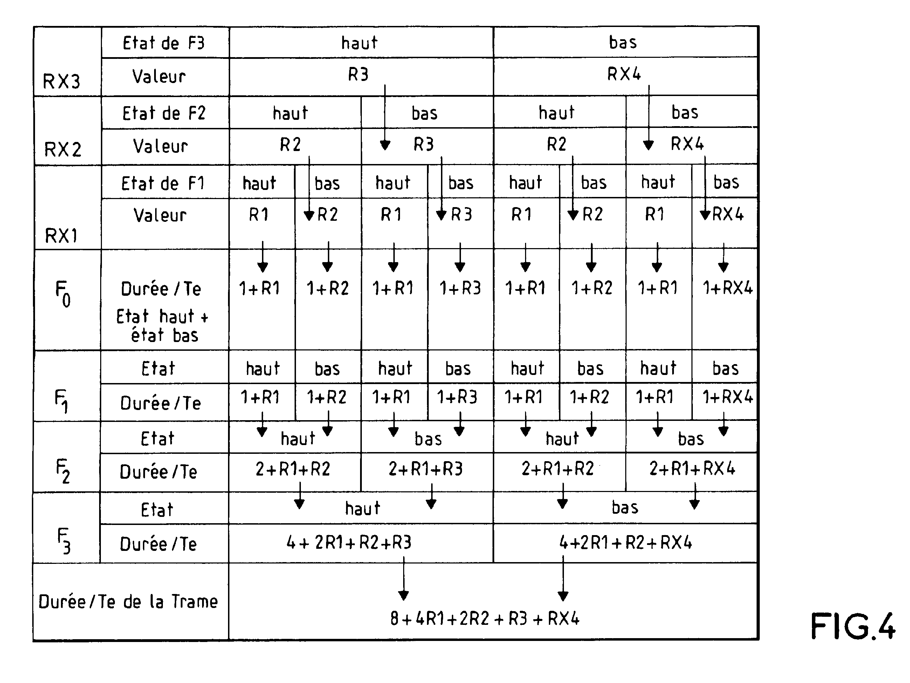

La figure 3 schématise un exemple de diviseur selon l'invention comprenant un étage d'adaptation 1/2, suivi de 3 étages de division par 2. Les conventions utilisées sont les suivantes : les diviseurs par 2 ($14_1$, $14_2$, $14_3$) changent d'état sur le front montant du signal d'entrée ($F_0$, $F_1$, $F_2$), les commandes $C_1$, $C_2$, $C_3$ des commutateurs $15_1$, $15_2$, $15_3$, sélectionnent les retenues RX2, RX3, RX4 venant de l'étage suivant sur les états bas des sorties F1, F2, F3 des diviseurs par 2.

Il est possible d'utiliser d'autres conventions sans changer les propriétés du diviseur à condition de respecter la règle suivante : l'étage K effectue la lecture de la retenue venant de l'étage K+1 sur l'état du signal F(K) qui est situé juste avant le front de F(K) qui déclenche les changements d'état pour l'étage K+1.

Le diviseur étant constitué de l'étage d'adaptation 1/2 suivi des étages de division $K_1$, $K_2$, $K_3$, la durée de trame de comptage du diviseur est définie par exemple, comme étant la période de temps constituée par un état haut et un état bas du signal de sortie du dernier étage (étage $K_3$ dans cet exemple, signal F3).

Cette trame de comptage comprend 2 cycles de comptage de l'étage $K_2$. Chaque cycle est constitué d'un état haut et d'un état bas dont les durées peuvent être différentes d'un cycle à l'autre selon la propagation des retenues RX. La trame de comptage contient donc 4 cycles de comptage de l'étage $K_1$ et 8 cycles de comptage de l'étage d'adaptation 10.

D'une façon générale, la trame de comptage contient $2^{(Kmax-P)}$ cycles de comptage de l'étage d'adaptation lorsque l'on cascade Kmax-P étages de division par 2 derrière l'étage d'adaptation. Chacun de ces cycles a une durée qui vaut NA ou NA+1 fois la période du signal d'entrée Fe.

La durée de ces 8 cycles de comptage est obtenue par la propagation des retenues au cours de la trame de comptage (cette propagation s'effectue de l'aval vers l'amont). Cette propagation est représentée dans le tableau 1 (figure 4) par les lignes RX3, RX2 et RX1. Ayant obtenu le signal RX1, on en déduit successivement les durées des différents états des signaux F0, F1, F2 et F3 (la déduction s'effectue de l'amont vers l'aval).

En final, on obtient la durée de la trame de comptage qui vaut : (8+4R1+2R2+R3+RX4)*Te, où Te est la période du signal d'entrée du diviseur.

Pour un étage d'adaptation 1/2 suivi de Kmax étages de division par 2 le rang de division obtenu est :

$$N = 2^{Kmax} + R\,(1).\,2^{Kmax-1} + R\,(2)\,2^{Kmax-2} + \ldots\ldots\ldots + R\,(Kmax) + RX\,(Kmax+1)$$

En prenant RX (Kmax + 1) = 0 (ce qui signifie que l'étage K est le dernier étage et qu'il ne reçoit pas de retenue), ce rang de division s'écrit en binaire de façon très simple puisque le MSB est un 1, puis les différents bits sont R(1), R (2) jusqu'à R (Kmax) qui constitue le LSB.

> Rang de division  N en binaire = 1 R (1) R (2)………….R (Kmax)

Ceci constitue un avantage du dispositif, le décodage qui permet de présenter aux différents étages les commandes R (1), R(2) ...., R(Kmax), est obtenu très simplement à partir du mot binaire présenté comme commande du rang de division N.

Le tableau 1 (figure 4) donne la propagation des retenues et la durée des états hauts et bas pour un étage d'adaptation 1/2 suivi de 3 étages. L'examen des lignes RX3, RX2 et RX1 de ce tableau montre que : en remontant la chaîne des commutateurs, les retenues (par exemple R3) sont redécoupées progressivement de telle sorte qu'elles sont présentées sans impulsions supplémentaires (en termes anglo-saxon glitch) pouvant apparaître par rapport aux niveaux logiques prévus à l'étage de tête (ici l'étage d'adaptation). La chaîne des commutateurs agit comme un « entonnoir » pour les retenues qui sont progressivement « resynchronisées » jusqu'à l'étage d'adaptation. Cet effet « entonnoir » est utilisé pour des raffinements de la structure du diviseur décrits ci-après.

Ce tableau 1 (figure 4) révèle aussi que chaque étage de division peut tolérer un retard quasiment égal à la durée de l'état haut du signal d'entrée de l'étage (compte tenu des conventions choisies), ce qui signifie que chaque étage du diviseur peut être dimensionné uniquement pour sa propre fréquence de travail. Un tel diviseur est donc optimal en terme de consommation.

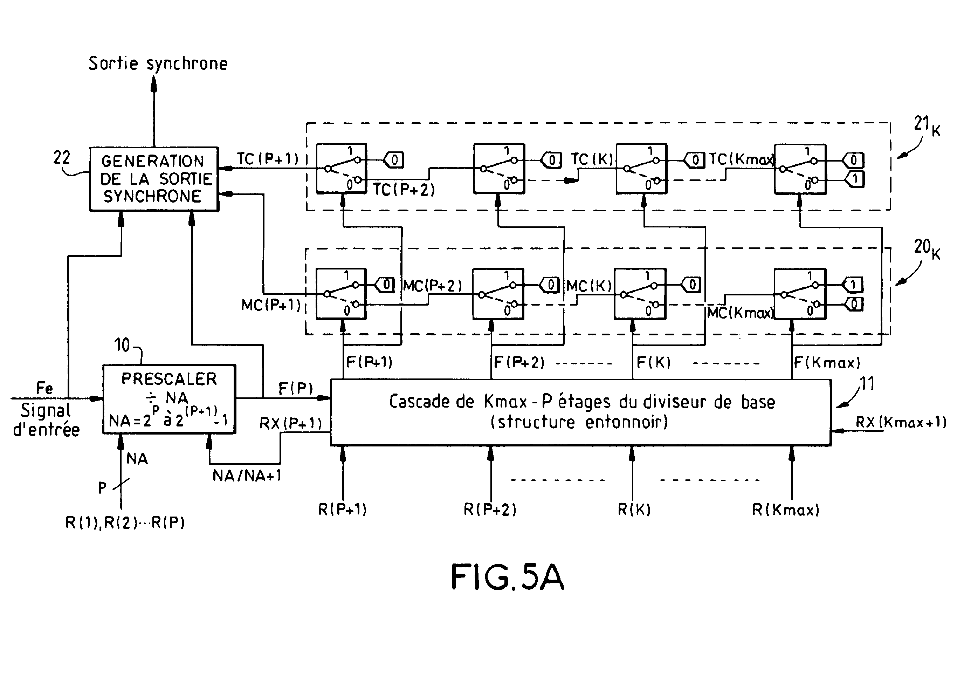

La figure 5A représente un synoptique d'une variante de réalisation d'un diviseur comportant une sortie synchrone. Par rapport à la structure, désignée comme structure de base ou structure entonnoir (référencée bloc 11 à la figure 2) et décrite à la figure 3, le dispositif selon l'invention comporte en plus :

- Une première chaîne de Kmax-P commutateurs $20_K$ commandés par les sorties F(P+1) à F(Kmax) des différents diviseurs de la structure entonnoir décrite à la figure 2. Le signal de sortie de cette première chaîne est un signal de milieu de comptage MC(P+1 ).
- Une deuxième chaîne de Kmax-P commutateurs $21_K$ commandés par les sorties F(P+1) à F(Kmax) des différents diviseurs de la structure entonnoir. Le signal de sortie de cette deuxième chaîne est un signal de fin de comptage TC(P+1).
- Un bloc 22 de génération de la sortie synchrone. Cette sortie est élaborée à partir de signaux TC(P+1) et/ou MC(P+1 ) et des horloges F(P) et/ou Fe. En effet, plusieurs types de sortie synchrone sont possibles suivant l'application envisagée.

La structure représentée à la figure 5A permet de changer le rang de division N de façon statique (c'est-à-dire qu'il y a un laps de temps de reconfiguration pendant lequel le signal de sortie n'est pas exploitable). Ce changement est effectué en modifiant les valeurs R(K) : on obtient alors un rang N qui peut varier entre $2^{Kmax}$ et $2^{Kmax+1}$. De plus, en gérant statiquement le nombre d'étages actifs de la structure entonnoir (par exemple en n'alimentant pas les étages non utilisés) on peut faire varier N de $2^{P+1}$ à $2^{Kmax+1}$.

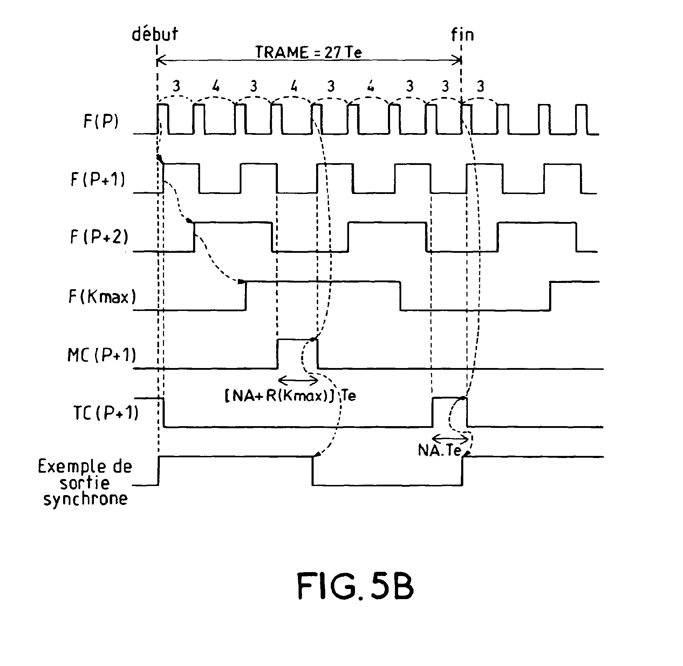

La figure 5B schématise un chronogramme des signaux comportant TC(P+1), MC(P+1 ) pour une division par 27 avec NA=3, P=1 et Kmax = 3. Dans cet exemple, l'instant du début de trame est défini de façon à repérer les signaux TC(P+1) et MC(P+1 ) par rapport à ce début de trame. Le début de trame désigne le flanc du signal F(P) (signal d'entrée de la structure entonnoir) qui déclenche en cascade le passage à 1 de tous les diviseurs par 2 de la structure entonnoir, compte tenu des conventions choisies.

Cette définition est retrouvée sur les chronogrammes de cette figure 5B où le début de la trame est le flanc montant de F(P) qui déclenche le passage à 1 de F(P+1) puis de F(P+2) jusqu'à F(Kmax).

Dans cet exemple de mise en oeuvre, les chaînes des commutateurs délivrant TC(P+1) et MC(P+1 ) sont pourvues à leurs entrées de niveaux logiques permettant d'obtenir une seule impulsion par trame pour chaque chaîne. Cette impulsion est découpée par F(P+1) donc elle est synchrone de F(P+1) et de durée égale à un cycle de l'étage d'adaptation. L'impulsion TC(P+1) sélectionne :

- ■ Soit le flanc de F(P) correspondant à la fin de la trame,
- ■ Soit un flanc de F(P) décalé par rapport à la fin de trame à la condition que ce décalage ait une durée constante quelque soit la valeur des données de programmation R(1) à R(Kmax).

L'impulsion MC(P+1 ) sélectionne le flanc de F(P) voisin du milieu de la trame.
Les signaux TC(P+1) et MC(P+1) permettent donc en sélectionnant les transitions adéquates de F(P) de générer un signal qui est l'image du signal de sortie de l'entonnoir F(Kmax), mais qui est synchrone de l'entrée de l'entonnoir F(P).

Une telle structure présente notamment les avantages suivants :

- La possibilité d'obtenir un diviseur synchrone quelque soit le nombre d'étages de la structure et donc quelque soit le rang de division,
- La possibilité d'obtenir un signal de sortie dont le bruit de phase est très proche de celui du signal d'entrée du diviseur et cela quelque soit le nombre d'étage de la structure et donc quelque soit le rang de division. En effet, le nombre de couches logiques entre l'entrée Fe et la sortie synchrone est minimisé. Il est aussi possible d'optimiser en bruit ce faible nombre de couches. Avec un étage d'adaptation de faible rang la resynchronisation est effectuée par Fe et le nombre de couches logiques entre l'entrée et la sortie synchrone est égale à 1.

Une manière d'obtenir le signal TC(K) qui représente la fin de comptage de l'étage K consiste à :

- Adopter la même convention que la structure entonnoir de sélection des retenues venant de l'étage K+1 sur les états bas de F(K),
- Positionner à 1 l'entrée du dernier commutateur sélectionnée par l'état bas de F(Kmax),
- Positionner à 0, l'entrée du dernier commutateur sélectionnée par l'état haut de F(Kmax),
- Positionner à 0 toutes les entrées commutateurs sélectionnées par l'état haut de F(P+1), F(P+2)....F(Kmax-1 ).

Une façon d'obtenir MC(K) consiste à :

- Adopter la même convention que la structure entonnoir de sélection des retenues venant de l'étage K+1 sur les états bas de F(K),
- Positionner à 1, l'entrée du dernier commutateur sélectionnée par l'état haut de F(Kmax),
- Positionner à 0, l'entrée du dernier commutateur sélectionnée par l'état bas de F(Kmax),
- Positionner à 0 toutes les entrées commutateurs sélectionnées par l'état haut de F(P+1), F(P+2), ...F(Kmax).

Différents types de sortie synchrone dont certains exemples non limitatifs sont donnés ci-après, sont envisageables.

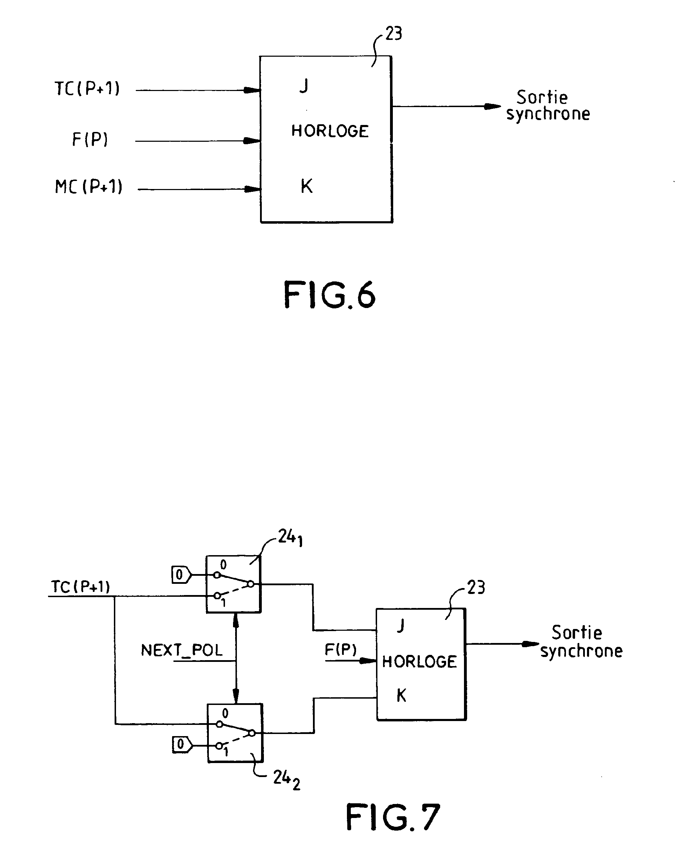

Le premier type, schématisé à la figure 6, est une sortie synchrone qui est à l'image de F(Kmax). Dans ce cas, on utilise les signaux MC(P+1) et TC(P+1) qui peuvent par exemple être combinés sur une bascule JK, référencée 23. L'horloge de la bascule JK est en général F(P) et Fe pour un étage d'adaptation de faible rang.

Un deuxième type de sortie synchrone est donné à la figure 7. Il consiste notamment à générer un état constant sur toute la durée de la trame et à choisir à l'aide d'un signal de commande NEXT_POL (next polarité qui permet de choisir une polarité de 0 ou 1 de la sortie synchrone pour la trame suivante - niveau constant sur une trame). Deux commutateurs $24_1$ et $24_2$ reçoivent chacun un signal TC(P+1) et NEXT_POL et qui sont positionnés juste avant la bascule JK référence 23. Dans ce type de sortie synchrone, on utilise uniquement le signal TC(P+1). Cette variante de réalisation peut aussi utiliser tout autre type de bascules.

Un troisième type de sortie synchrone (non représentée sur les figures) consiste notamment à envoyer la sortie TC(P+1) sur les entrées J et K de façon à obtenir alternativement un état haut et un état bas, chaque état ayant la durée donnée par N*Te où Te est la période d'entrée de l'horloge et N est le rang de division global.

La sortie synchrone présentée sur les figures 5A à 8, est une resynchronisation sur F(P) qui est la sortie de l'étage d'adaptation ou sur Fe qui est l'entrée de l'étage d'adaptation. Une resynchronisation sur l'entrée Fe de l'étage d'adaptation permet d'obtenir des performances accrues de bruit de phase.

Les signaux de base pour effectuer de façon optimale cette resynchronisation sont :

- TC(P+1 ) reéchantillonné par F(P),
- MC(P+1 ) reéchantillonné par F(P).

D'autres solutions de resynchronisation sur Fe sont possibles en imposant des contraintes de fonctionnement sur l'étage d'adaptation comme par exemple, de présenter un état de son cycle de sortie avec une durée constante. Dans le dispositif selon l'invention, les signaux TC(P+1), MC(P+1 ) et RX(P+1) sont obtenus sans impulsions supplémentaires. Ceci est du au principe de la structure entonnoir qui travaille avec des propagations inverses : amont vers aval pour la chaîne des diviseurs par 2, aval vers amont pour les chaînes RX, TC et MC.

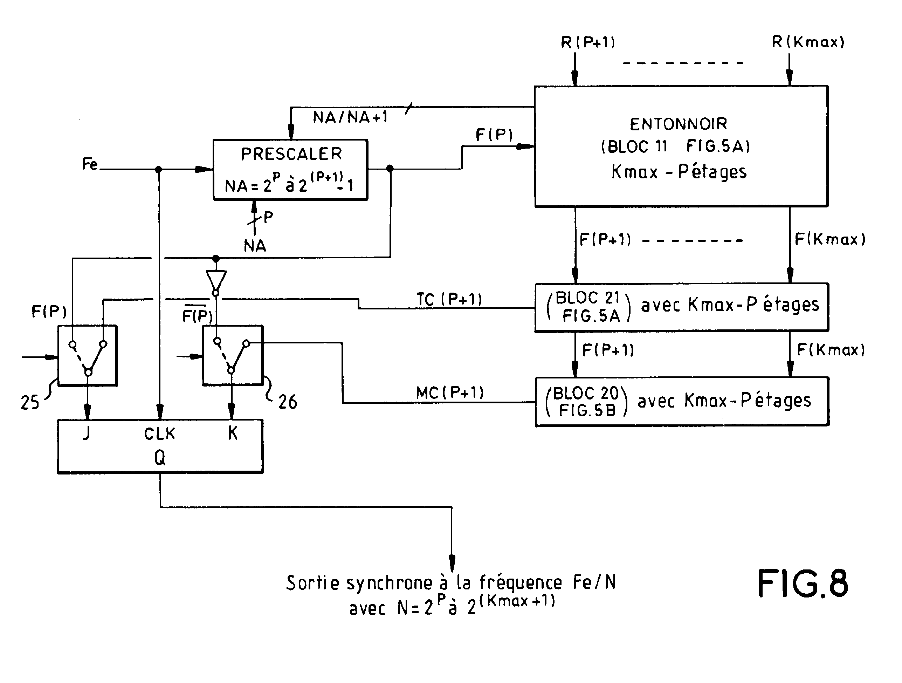

La figure 8 présente une variante de réalisation permettant d'obtenir sur la sortie synchrone un signal divisé de fréquence Fe/N avec N pouvant varier statiquement de $2^P$ à $2^{(Kmax+1)}$.

Par rapport à la structure décrite à la figure 5A, la structure comporte deux commutateurs 25 et 26 qui reçoivent respectivement la sortie de l'étage d'adaptation F(P) et son complémentaire $\overline{F(P)}$ .. Le bloc 22 comporte une bascule 23 par exemple de type JK. La bascule JK de sortie synchonre est pourvu sur J du commutateur 25 permettant de faire J=F(P) ou J=TC(P+1) et est pourvu sur K du commutateur 26 permettant de faire K= $K=\overline{F(P)}$ ou K=MC(P+1). Avec cette variante le rang de division N commence au rang minimum de l'étage d'adaptation.

## Changement dynamique du rang de division

Il est possible selon l'invention de choisir un nouveau rang de division de trame en trame (changement dynamique).

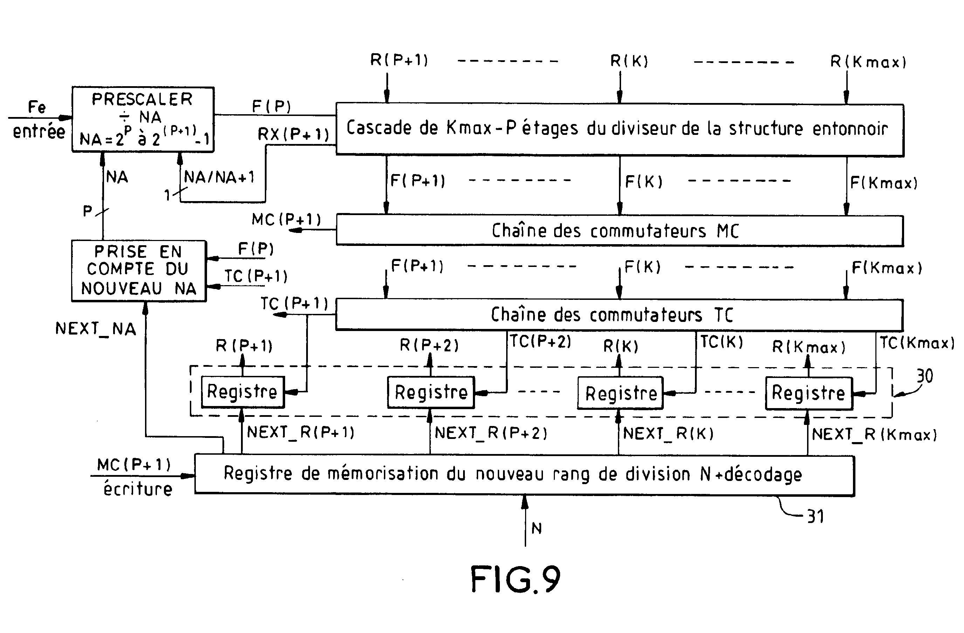

La figure 9 schématise un exemple de structure permettant d'effectuer le changement de rang de division de trame en trame, c'est-à-dire que pendant qu'une trame se déroule, on donne au dispositif de division un nouveau rang de division pour la trame suivante. Cette nouvelle trame débutera en parfaite continuité dès la fin de la trame précédente.

Elle comporte un étage d'adaptation 10 divisant par NA variant de N0 à 2*N0-1, par exemple de $2^P$ à $2^{(P+1)}$-1, suivi de Kmax-P étages correspondant à la structure entonnoir (structure détaillée à la figure 2) ainsi que les chaînes de commutateurs délivrant TC(P+1) et MC(P+1) selon la structure synchrone décrite à la figure 5A. Une première rangée 30 de registres sont commandés par les sorties intermédiaires de la chaîne TC et une deuxième rangée 31 de registres sont commandés par le signal MC(P+1 ).

Le fonctionnement de la prise en compte du nouveau rang de division s'effectue par exemple de la façon suivante :

■ En milieu de trame, le signal MC(P+1 ), prend en compte le nouveau rang de division pour la trame suivante en mémorisant NEXT_R(1), NEXT_R(2), .....NEXT_R(Kmax).

■ En remontant la chaîne des commutateurs TC, le signal de fin de trame induit successivement une transition d'états des signaux TC(Kmax), TC(Kmax-1 ),..TC(P+1) qui permettent de transférer tous les NEXT_R(K) dans les registres R(K) correspondants. Par le principe même de la chaîne TC, ce transfert a lieu lorsque le R(K) précédent n'est plus utilisé par l'étage K de l'entonnoir (structure de base schématisée à la figure 2).

Pour le diviseur selon la figure 9, il est possible de commuter dynamiquement le rang de division N sur un octave de $2^{Kmax}$ à $2^{(Kmax+1)}$.

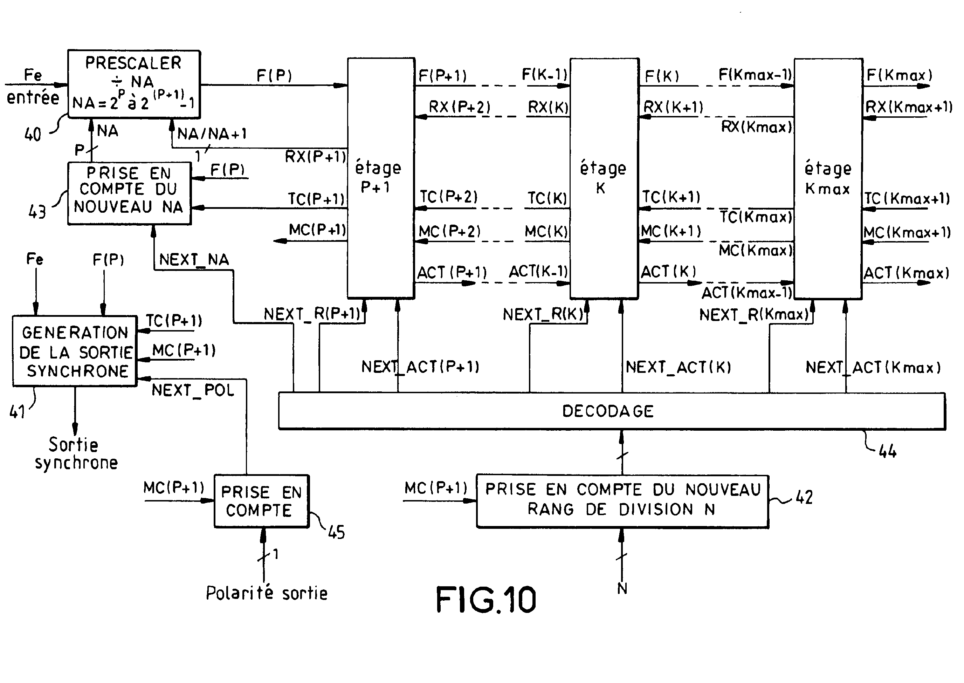

La figure 10 représente un synoptique d'un diviseur à rang multi-octaves. Un tel schéma permet notamment de commuter dynamiquement le rang de division sur plusieurs octaves.

Le diviseur comporte par exemple :

- Un étage d'adaptation 40 ayant pour fonction de diviser par NA variant de N0 à 2*N0-1, par exemple de $2^P$ à $2^{(P+1)}$-1 avec une commande NA/(NA+1 ),
- Kmax-P étages de division de structure identique ou sensiblement identique qui sont cascadés derrière l'étage d'adaptation,
- Un bloc de génération 41 de la sortie synchrone identique ou sensiblement identique à celui de la structure décrite à la figure 5A,
- Une fonction de prise en compte 42 en milieu de trame du rang de division pour la trame suivante, cette fonction reçoit le signal d'écriture MC(P+1 ),
- Une fonction 43 élaborant le signal de prise en compte du nouveau rang de division NA de l'étage d'adaptation,
- Une fonction 44 de décodage permettant d'extraire les informations NEXT_R(K) (K varie de 1 à Kmax, NEXT_R(K) donne la valeur de N pour la trame suivante), NEXT_ACT(K) (K varie de P+1 à Kmax, NEXT_ACT(K) indique si l'étage K est actif ou non actif pour la trame suivante) et NEXT_NA (donne la valeur de NA de l'étage d'adaptation pour la trame suivante), à partir du mot de commande N,
- Eventuellement une fonction 45, de prise en compte de la polarité du signal de sortie synchrone pour la prochaine trame.

Une telle structure permet avantageusement de gérer de manière dynamique la longueur de comptage et donc d'obtenir un rang de division commutable de trame en trame, de la valeur $2^{(P+1)}$ (rang maximum de division de l'étage d'adaptation) et $2^{(Kmax+1)}$ (rang maximum de division lorsque tous les étages du dispositif sont actifs).

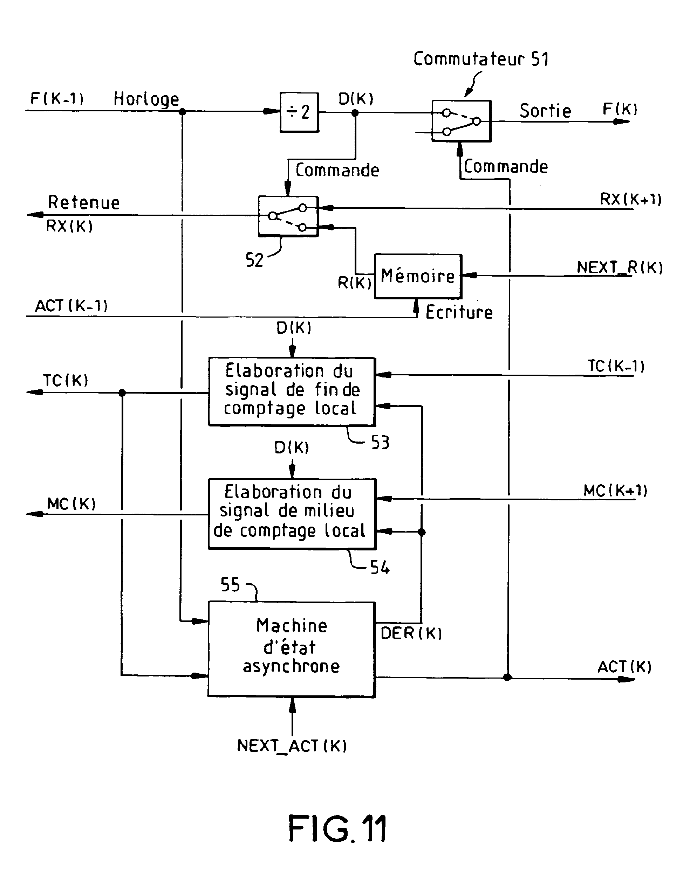

La figure 11 schématise un synoptique d'un étage situé derrière l'étage d'adaptation. La description est donnée à titre d'exemple pour l'étage d'indice K.

L'étage K comporte par exemple :

- Un diviseur par 2 référencé 50 qui reçoit de l'étage précédent (K-1) le signal F(K-1) et qui délivre le signal divisé D(K),

- Un commutateur 51 qui reçoit D(K) sur l'une de ses entrées, l'autre recevant 0, et qui délivre le signal de sortie de l'étage K qui est fourni à l'étage suivant,
- Un commutateur 52 commandé par D(K) de façon à transmettre alternativement sur sa sortie nommée : RX(K) :

- La valeur de la donnée de programmation R(K) pour un état du diviseur par 2,
- La valeur de la retenue RX(K+1) provenant de l'étage suivant pour l'autre état du diviseur par 2. La retenue RX (K+1) a une durée supérieure aux états du diviseur de l'étage K. Elle est donc découpée par l'étage K.
- Une fonction 53 dont le rôle est d'élaborer un signal appelé TC(K) qui signifie la fin de comptage pour l'étage K. Pour élaborer TC(K), cette fonction utilise les signaux TC(K+1) (correspondant à la fin de comptage de l'étage suivant), D(K) (sortie du diviseur par 2) et le signal DER(K) qui signifie, suivant sa valeur 0 ou 1, que l'étage K est ou n'est pas le dernier étage.
- Une fonction 54 dont le rôle est d'élaborer un signal appelé MC(K) qui signifie le milieu de comptage pour l'étage K. Pour élaborer MC(K) cette fonction utilise les signaux MC(K+1) (milieu de comptage de l'étage suivant), D(K) (sortie du diviseur par 2) et le signal DER(K) qui signifie, suivant sa valeur 0 ou 1 que l'étage K est ou n'est pas le dernier étage.
- Une machine d'état asynchrone 55 qui comporte un ou plusieurs éléments de mémorisation.
- une bascule 56 de mémorisation de la retenue locale R(K). Cette bascule reçoit comme donnée d'entrée NEXT_R (K). L'écriture de cette bascule est réalisé par le signal ACT(K-1) provenant de l'étage précédent. Pour le premier étage P+1 de la structure entonnoir, le signal ACT(P) est le signal TC(P+1).

La machine d'état 55 fonctionne avec une donnée qui est le signal NEXT_ACT(K) et avec deux signaux d'horloge qui sont F(K-1) et TC(K). Les signaux d'horloge cadence la succession des états de la machine en fonction de la donnée NEXT_ACT(K) et en fonction de l'état d'une ou plusieurs bascules de mémorisation internes à la machine.

La machine d'état délivre les signaux DER(K) et ACT(K). Le signal DER(K) sert à gérer la qualité de dernier étage pour l'étage K et est utilisé par les fonctions élaborant les signaux de milieu et de fin de comptage de l'étage K.

Le signal ACT(K) est un signal d'activation pour l'étage suivant. Le signal d'activation commande le commutateur situé en sortie du diviseur par 2. Il est également transmis à l'étage suivant.

**Fonctionnement de l'étage K**

On se bornera à donner le fonctionnement des nouvelles fonctions par rapport à la structure précédemment décrite dans le paragraphe consacré à la sortie synchrone. Ces nouvelles fonctions sont essentiellement :

- la fonction élaborant le signal de fin de comptage,

- la fonction élaborant le signal de milieu de comptage,

- la machine d'état asynchrone.

Lorsque l'étage K n'est pas le dernier étage, les fonctions de milieu et de fin de comptage fonctionnent comme dans le schéma décrivant le fonctionnement de la structure entonnoir avec sortie synchrone: c'est-à-dire que TC(K+1) et MC(K+1) sont redécoupés par le signal D(K) pour donner respectivement TC(K) et MC(K).

Lorsque l'étage K est le dernier étage c'est le signal DER(K) qui est découpé par D(K) et transmis sur MC(K) pendant la 1 ère partie de la trame et sur TC(K) pendant la 2ème partie de la trame.

La machine d'état asynchrone comprend au moins une bascule de mémorisation ACT(K) qui mémorise l'état actif ou non actif de l'étage suivant. Le détail du cycle de fonctionnement de la machine d'état décrit ci-après est un mode de réalisation préférentiel qui est donné à titre d'exemple.

Il est bien évident que des modifications de ce cycle de fonctionnement sont possibles sans changer l'esprit de l'invention.

**Mode de fonctionnement préférentiel**

En début de trame, toutes les bascules ACT(K) et tous les diviseurs sont à zéro et l'étage (P+1 ) est considéré comme dernier étage.

Le premier front de F(K-1) (par rapport au début de la trame tel qu'il a été défini au paragraphe précédent) écrit la valeur NEXT_ACT(K) dans la bascule de mémorisation ACT(K). Si et seulement si l'étage suivant est actif, la sortie ACT(K) de cette bascule de mémorisation provoque les deux événements suivants:

1. le commutateur de sortie transmet le signal D(K) sur la sortie F(K) qui est l'entrée du diviseur par 2 de l'étage suivant qui va donc, d'une part, se mettre à compter, et d'autre part, écrire la bascule ACT(K+1) gérant l'activité de l'étage K+2;

2. le signal ACT(K) effectue l'écriture de la bascule de mémorisation de la retenue R(K+1).

Le front de TC(K) signifiant le début de la fin de comptage pour l'étage K effectue la remise à zéro de la bascule ACT(K).

Ainsi lorsque le signal TC remonte la chaîne des étages en partant du dernier actif vers le premier (qui est toujours P+1), il remet à zéro l'ensemble des bascules ACT(K) et ouvre donc les commutateurs situés entre les diviseurs de façon à laisser tous les diviseurs dans l'état zéro. En fin de trame toutes les bascules ACT(K) et tous les diviseurs sont donc revenus à l'état initial et l'étage (P+1) est considéré comme dernier étage.

Avantageusement, on obtient ainsi une gestion dynamique du nombre d'étages actifs : de trame en trame on peut choisir n'importe quel N entre $2^{P+1}$ et $2^{Kmax+1}$.

Cette variante de réalisation incluant une machine d'état asynchrone simple dans chaque étage du diviseur permet d'obtenir un rang de division variant de $2^{P+1}$ (rang maximum de division de l'étage d'adaptation) à $2^{Kmax+1}$ (rang maximum de division lorsque tous les étages du dispositif sont actifs). Ce diviseur a encore une consommation optimale car toute la gestion du fonctionnement travaille à la vitesse de l'étage concerné et elle n'effectue qu'un nombre réduit d'opérations par trame (et non par cycle ce qui fait une grande différence).

## Machine d'état asynchrone

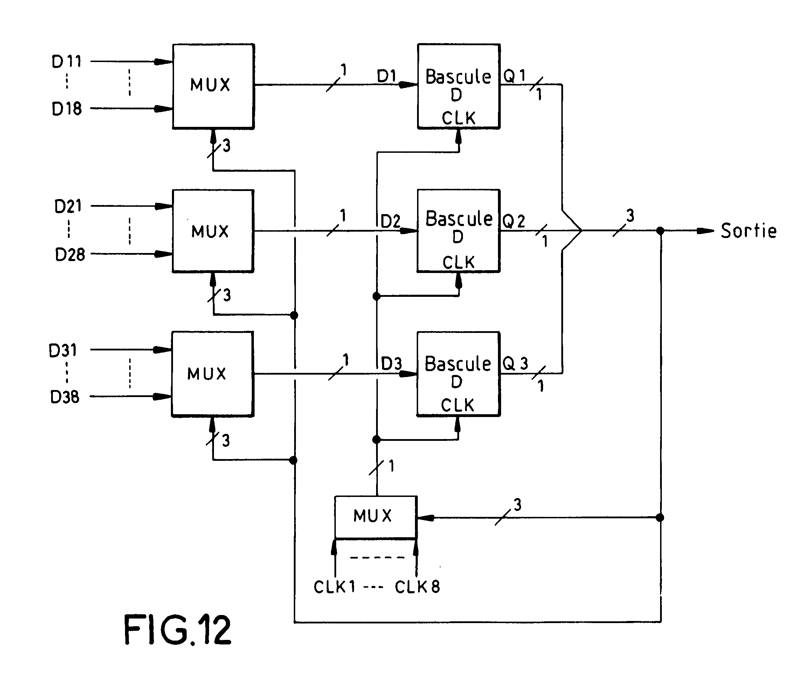

La figure 12 donne le schéma de la machine d'état asynchrone à 8 états, c'est-à-dire pour N=3.

Dans sa généralité cette machine d'état est constituée de N bascules D qui partagent la même entrée horloge appelée CLK. Un mot particulier de N bits stocké dans ces bascules D représente un état de la machine. On a donc $2^N$ états possibles de la machine.

L'entrée CLK est connectée à la sortie d'un commutateur à $2^N$ positions qui est commandé par le mot d'état de la machine, c'est-à-dire par le bus de N bits constitué par l'ensemble des sorties Q des bascules D.

Les $2^N$ entrées de ce commutateur sont les $2^N$ signaux d'horloge qui cadence la succession des états de la machine. Chaque entrée D de chaque bascule est également connectée à la sortie d'un commutateur à $2^N$ entrées qui est commandé par le bus de N bits de sortie de la machine. Comme on a N bascules on a N commutateurs d'entrée qui possèdent chacun $2^N$ entrées, on a donc au total $N*2^N$ entrées de données pour la machine.

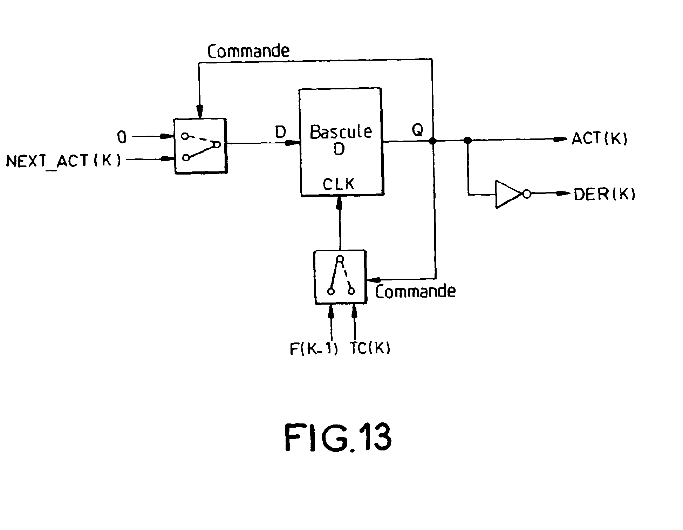

La figure 13 donne le schéma de la machine d'état pour l'application diviseur de fréquence. On a une seule bascule D.

- Les entrées horloges sont F(K-1) et TC(K).

- Les entrées données sont NEXT_ACT(K) et 0.

- La sortie Q de la bascule D commande les deux commutateurs situés sur D et sur CLK.

- La sortie ACT(K) est la sortie Q.

- La sortie DER(K) est le complément de Q.

- Lorsque Q est à 0 l'horloge est F(K-1) et la donnée est NEXT_ACT(K) $\Rightarrow$ le 1$^{er}$ front de F(K-1) écrit la valeur ACT (K). Lorsque Q est à 1 l'horloge est TC(K) et la donnée est 0 $\Rightarrow$ le 1$^{er}$ front de TC(K) remet à zéro la bascule D.

## Revendications

1. Diviseur de fréquence permettant de diviser par N une fréquence Fe comportant au moins un étage d'adaptation (10) suivi d'une chaîne de division (11), **caractérisé en ce que** :

   • l'étage d'adaptation (10) a au moins une entrée pour le signal de fréquence à diviser Fe, une entrée pour une commande NA du rang de base de division de l'étage d'adaptation et une entrée pour une commande ΔNA provenant de la chaîne de division (11) et permettant de faire varier NA d'une unité,
   • la chaîne de division (11) comporte au moins un étage (K) de division comportant au moins un diviseur par 2 fournissant une fréquence divisée F(K), un commutateur ($15_K$) commandé par le diviseur par 2 ($14_K$), le commutateur ($15_K$) a une entrée pour une donnée de programmation R(K), une entrée pour le signal de retenue RX(K+1) de l'étage suivant et une sortie pour le signal de retenue RX(K) pour l'étage précédent.

2. Diviseur de fréquence selon la revendication 1 **caractérisé en ce que** la commande NA varie de N0 à 2*N0-1.

3. Diviseur de fréquence selon la revendication 2 **caractérisé en ce que** la commande NA varie de $2^P$ à $2^{(P+1)}$-1.

4. Diviseur de fréquence selon la revendication 1 **caractérisé en ce qu'**il comporte une première chaîne de commutateurs ($20_K$) commandés par les sorties F(K) des diviseurs ($14_K$) et fournissant un signal MC(P+1), une deuxième chaîne de commutateurs ($21_K$) commandés par les sorties F(K) des diviseurs ($14_K$) et fournissant un signal TC (P+1), un bloc (22) de génération d'une sortie synchrone élaborée à partir des signaux TC(P+1), MC(P+1) et du signal d'entrée Fe ou F(P) de sortie de l'étage d'adaptation.

5. Diviseur de fréquence selon la revendication 4 **caractérisé en ce que** le bloc de génération (22) est une bascule de type JK (23) qui reçoit les signaux MC(P+1) et TC(P+1) et Fe ou F(P).

6. Diviseur de fréquence selon la revendication 4 **caractérisé en ce qu'**il comporte au moins une deuxième chaîne de commutateurs ($21_K$) commandés par les sorties F(K) des diviseurs ($14_K$) et fournissant un signal TC(P+1), au moins deux commutateurs ($26_1$) et ($26_2$) recevant le signal TC(P+1) et fournissant deux signaux à une bascule (23) recevant le signal d'entrée ou le signal de sortie de l'étage d'adaptation.

7. Diviseur de fréquence selon la revendication 4 **caractérisé en ce qu'**il comporte une première rangée de registres (30) commandés par les sorties intermédiaires de la chaîne (TC) et une deuxième rangée de registres (31) commandés par le signal MC(P+1).

8. Diviseur de fréquence selon la revendication 4 **caractérisé en ce qu'**il comporte :

   ■ une fonction de prise en compte (42) en milieu de trame du rang de division pour la trame suivante, cette fonction reçoit le signal d'écriture MC(P+1),

   • une fonction (43) élaborant le signal de prise en compte du nouveau rang de division NA de l'étage d'adaptation,
   • une fonction (44) de décodage permettant d'extraire les informations NEXT_R(K), NEXT_ACT(K) et NEXT_NA à partir du mot de commande N.

9. Diviseur de fréquence selon la revendication 8 **caractérisé en ce qu'**il comporte une fonction (45) de prise en compte de la polarité du signal de sortie synchrone pour la prochaine trame.

10. Utilisation du diviseur selon l'une des revendications 1 à 9 dans le domaine de la synthèse de fréquence à boucles de phase.

11. Utilisation du diviseur selon l'une des revendications 1 à 9 pour un générateur d'impulsions.

## Claims

1. Frequency divider enabling the division by N of a frequency Fe and comprising at least one prescaler (10) followed by a division chain (11), **characterized in that**:

   - the prescaler (10) has at least one input for the frequency signal Fe to be divided, one input for a command NA of a basic division rank of the prescaler and one input for a command ΔNA coming from the division chain (11) and enabling NA to be made to vary by one unit,
   - the division chain (11) comprises at least one division stage (K) comprising at least one divider by 2, giving a divided frequency F(K), a switch ($15_K$) controlled by the divider by 2 ($14_K$), the switch ($15_K$) having one input for a piece of programming data R(K), one input for the carry signal RX(K+1) of the next stage and one output for the carry signal RX(K) for the previous stage.

2. Frequency divider according to Claim 1 **characterized in that** the command NA varies from N0 to 2*N0-1.

**3.** Frequency divider according to Claim 2 **characterized in that** the command NA varies from $2^P$ to $2^{(P+1)}$-1.

**4.** Frequency divider according to Claim 1 **characterized in that** it comprises a first chain of switches ($20_K$) controlled by the outputs F(K) of the dividers ($14_K$) and giving a signal MC(P+1), a second chain of switches ($21_K$) controlled by the outputs F(K) of the dividers ($14_K$) and giving a signal TC(P+1) and a module (22) for the generation of a synchronous output prepared from the signals TC(P+1), MC(P+1) and the input signal F(e) or output signal F(P) of the prescaler.

**5.** Frequency divider according to Claim 4 **characterized in that** the generation module (22) is a JK-type flip-flop (23) that receives the signals MC(P+1) and TC(P+1) and Fe or F(P).

**6.** Frequency divider according to Claim 4 **characterized in that** it comprises at least one second chain of switches ($21_K$) controlled by the outputs F(K) of the dividers ($14_K$) and giving a signal TC(P+1), at least two switches ($26_1$) and ($26_2$) receiving the signal TC(P+1) and giving two signals to a flip-flop (23) receiving the input signal or the output signal of the prescaler.

**7.** Frequency divider according to Claim 4 **characterized in that** it comprises a first row of registers (30) controlled by the intermediate outputs of the chain (TC) and a second row of registers (31) controlled by the signal MC(P+1).

**8.** Frequency divider according to Claim 4 **characterized in that** it comprises:

• a function (42) for taking into account in mid-frame the division rank for the next frame, this function receiving the write signal MC(P+1),
• a function (43) preparing the signal for taking account of the new division rank NA of the prescaler,
• a decoding function (44) enabling extraction of the pieces of information NEXT_R(K), NEXT_ACT(K) and NEXT_NA from the control word N.

**9.** Frequency divider according to Claim 8 **characterized in that** it comprises a function (45) for taking account of the polarity of the synchronous output signal for the next frame.

**10.** Use of the divider according to one of Claims 1 to 9 in the field of phase-loop frequency synthesis.

**11.** Use of the divider according to one of Claims 1 to 9 for a pulse generator.

**Patentansprüche**

**1.** Frequenzteiler, der das Teilen einer Frequenz Fe durch N erlaubt, der mindestens eine Anpassungsstufe (10) gefolgt von einer Teilungskette (11) aufweist, **dadurch gekennzeichnet, dass**:

• die Anpassungsstufe (10) mindestens einen Eingang für das zu teilende Frequenzsignal Fe, einen Eingang für einen Befehl NA des Basisteilungsrangs der Anpassungsstufe und einen Eingang für einen Befehl ΔNA hat, der von der Teilungskette (11) kommt und es erlaubt, NA um eine Einheit variieren zu lassen,
• die Teilungskette (11) mindestens eine Teilungsstufe (K) aufweist, die mindestens einen Teiler durch 2 aufweist, der eine geteilte Frequenz F(K) liefert, einen Umschalter ($15_K$), der von dem Teiler durch 2 ($14_K$) gesteuert wird, wobei der Umschalter ($15_K$) einen Eingang für eine Programmierinformation R(K), einen Eingang für das Rückhaltesignal RX(K+1) der darauf folgenden Stufe und einen Ausgang für das Rückhaltesignal RX(K) für die vorhergehende Stufe hat.

**2.** Frequenzteiler nach Anspruch 1, **dadurch gekennzeichnet, dass** der Befehl NA von N0 bis 2*N0-1 variiert.

**3.** Frequenzteiler nach Anspruch 2, **dadurch gekennzeichnet, dass** der Befehl NA von $2^P$ bis $2^{(P+1)}$-1 variiert.

**4.** Frequenzteiler nach Anspruch 1, **dadurch gekennzeichnet, dass** er eine erste Kette von Umschaltern ($20_K$) aufweist, die von den Ausgängen F(K) der Teiler ($14_K$) gesteuert werden und ein Signal MC(P+1) liefern, eine zweite Kette von Umschaltern ($21_K$), die von den Ausgängen F(K) der Teiler ($14_K$) gesteuert werden und ein Signal TC(P+1) liefern, einen Block (22) zum Erzeugen eines synchronen Ausgangs, der ausgehend von den Signalen TC(P+1), MC(P+1) und dem Eingangssignal Fe oder F(P) des Ausgangs der Anpassungsstufe erstellt wird.

5. Frequenzteiler nach Anspruch 4, **dadurch gekennzeichnet, dass** der Erzeugerblock (22) eine Kippschaltung des Typs JK (23) ist, die die Signale MC(P+1) und TC(P+1) sowie Fe oder F(P) empfängt.

6. Frequenzteiler nach Anspruch 4, **dadurch gekennzeichnet, dass** er mindestens eine zweite Kette von Umschaltern $(21_K)$ aufweist, die von den Ausgängen F(K) der Teiler $(14_K)$ gesteuert werden und ein Signal TC(P+1) liefern, wobei mindestens zwei Umschalter $(26_1)$ und $(26_2)$ das Signal TC (P+1) empfangen und zwei Signale zu einer Kippschaltung (23) liefern, die das Eingangssignal oder das Ausgangssignal der Anpassungsstufe empfängt.

7. Frequenzteiler nach Anspruch 4, **dadurch gekennzeichnet, dass** er eine erste Reihe von Registern (30) aufweist, die von den Zwischenausgängen der Kette (TC) gesteuert werden, und eine zweite Reihe von Registern (31), die von dem Signal MC(P+1) gesteuert werden.

8. Frequenzteiler nach Anspruch 4, **dadurch gekennzeichnet, dass** er Folgendes aufweist:

   • eine Berücksichtigungsfunktion (42) in der Rahmenmitte des Teilungsrangs für den darauf folgenden Rahmen, wobei diese Funktion das Signal zum Schreiben MC(P+1) empfängt,
   • eine Funktion (43), die das Berücksichtungssignal des neuen Teilungsrangs NA der Anpassungsstufe erstellt,
   • eine Decodierfunktion (44), die es erlaubt, die Informationen NEXT_R (K), NEXT_ACT (K) und NEXT_NA ausgehend von dem Steuerwort N zu extrahieren.

9. Frequenzteiler nach Anspruch 8, **dadurch gekennzeichnet, dass** er eine Berücksichtigungsfunktion (45) der Polung des synchronen Ausgangssignals für den nächsten Rahmen aufweist.

10. Einsatz des Teilers gemäß einem der Ansprüche 1 bis 9 in dem Gebiet der Frequenzsynthese mit Phasenschleifen.

11. Einsatz des Teilers gemäß einem der Ansprüche 1 bis 9 für einen Impulsgenerator.

FIG.1

FIG.3

FIG.2

| | Etat de F3 | haut | | | | bas | | | |
|---|---|---|---|---|---|---|---|---|---|---|
| RX3 | Valeur | R3 | | | | RX4 | | | |
| | Etat de F2 | haut | | bas | | haut | | bas | |
| RX2 | Valeur | R2 | | R3 | | R2 | | RX4 | |
| | Etat de F1 | haut | bas | haut | bas | haut | bas | haut | bas |
| RX1 | Valeur | R1 | R2 | R1 | R3 | R1 | R2 | R1 | RX4 |
| $F_0$ | Durée / Te  Etat haut + état bas | 1+R1 | 1+R2 | 1+R1 | 1+R3 | 1+R1 | 1+R2 | 1+R1 | 1+RX4 |
| | Etat | haut | bas | haut | bas | haut | bas | haut | bas |
| $F_1$ | Durée / Te | 1+R1 | 1+R2 | 1+R1 | 1+R3 | 1+R1 | 1+R2 | 1+R1 | 1+RX4 |
| | Etat | haut | | bas | | haut | | bas | |
| $F_2$ | Durée / Te | 2+R1+R2 | | 2+R1+R3 | | 2+R1+R2 | | 2+R1+RX4 | |
| | Etat | haut | | | | bas | | | |
| $F_3$ | Durée / Te | 4+2R1+R2+R3 | | | | 4+2R1+R2+RX4 | | | |
| Durée/Te de la Trame | | 8+4R1+2R2+R3+RX4 | | | | | | | |

FIG.4

EP 1 445 865 B1

FIG.5A

début                                              fin

TRAME = 27 Te

3    4    3    4    3    4    3    3    3

F(P)

F(P+1)

F(P+2)

F(Kmax)

MC(P+1)

[NA+R(Kmax)] Te

TC(P+1)

NA.Te

Exemple de
sortie
synchrone

FIG. 5B

FIG.6

FIG.7

FIG.8

EP 1 445 865 B1

R(P+1) ――――――― R(K) ――――――― R(Kmax)

| Fe | PRESCALER | F(P) | | |
|---|---|---|---|---|
| entrée | ÷ NA | | Cascade de Kmax-P étages du diviseur de la structure entonnoir | |
| | NA=2^P à 2^(P+1)-1 | RX(P+1) | | |

NA | NA/NA+1

P ╱ | 1 ╱

F(P+1) ――――――― F(K) ――――――― F(Kmax)

MC(P+1)

| Chaîne des commutateurs MC |
|---|

| PRISE EN | F(P) |
|---|---|
| COMPTE DU | TC(P+1) |
| NOUVEAU NA | |

F(P+1) ――――――― F(K) ――――――― F(Kmax)

TC(P+1)

| Chaîne des commutateurs TC |
|---|

NEXT_NA

R(P+1)  R(P+2)  TC(P+2)  R(K)  TC(K)  R(Kmax)  TC(Kmax)

| Registre | Registre | ――― | Registre | ――― | Registre | 30 |
|---|---|---|---|---|---|---|

NEXT_R(P+1)  NEXT_R(P+2)  NEXT_R(K)  NEXT_R(Kmax)

| MC(P+1) | Registre de mémorisation du nouveau rang de division N+décodage | |
|---|---|---|
| écriture | | 31 |

N

## FIG.9

FIG.10

FIG.11

EP 1 445 865 B1

FIG.12

FIG.13

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6035182 A